# EUROPEAN PATENT APPLICATION

(11) **EP 4 369 859 A1**
(43) Date of publication of application: **15.05.2024**
(21) Application number: 22837294.2
(22) Date of filing: 29.03.2022
(51) Int. Cl.: H05B 3/00

(54) **ABNORMALITY DETERMINATION DEVICE, ABNORMALITY DETERMINATION METHOD, AND ABNORMALITY DETERMINATION SYSTEM**

(30) Priority: 09.07.2021 JP 2021114419; 26.08.2021 JP 2021138093
(71) Applicant: OMRON Corporation, Kyoto-shi, Kyoto 600-8530 (JP)
(72) Inventor: TAKATANI, Ryohei, Kyoto-shi, Kyoto 600-8530 (JP); YAMAGUCHI, Shohei, Kyoto-shi, Kyoto 600-8530 (JP); YAMADA, Takaaki, Kyoto-shi, Kyoto 600-8530 (JP)
(74) Representative: HGF
(86) International application number: PCT/JP2022/015640
(87) International publication number: WO 2023/281873

(57) **Abstract**

An abnormality determination device includes: an acquisition unit configured to acquire a resistance value of an electric heating element calculated from a voltage across the electric heating element of a heater and a current flowing through the electric heating element and configured to acquire a temperature value of the heater; a first determination unit configured to perform abnormality determination based on the acquired resistance value; a second determination unit configured to determine whether or not the acquired temperature value is in a temperature settling state where the acquired temperature value is within a width with respect to a first target value; and a third determination unit configured to determine whether or not the acquired resistance value is in a resistance settling state where the acquired resistance value is within a width with respect to a second target value. The first determination unit performs the abnormality determination when the second determination unit determines that the temperature settling state is established over a first period and the third determination unit determines that the resistance settling state is established over a second period.

## Description

### BACKGROUND

### TECHNICAL FIELD

The present disclosure relates to an abnormality determination device, an abnormality determination method, and an abnormality determination system that determine an abnormality of a heater.

### BACKGROUND ART

Patent document 1 discloses an electric heater that determines an abnormality of a heater based on a magnitude of a change in an electric resistance increase rate during energization.

### CITATION LIST

### PATENT LITERATURE

Patent Literature 1: JP H8-124653 A

### SUMMARY

### PROBLEMS TO BE SOLVED BY THE INVENTION

The electric resistance of the heater wire of the electric heater has temperature characteristics. Since the electric heater in Patent Document 1 does not include a sensor for detecting a temperature of the heater wire, it may not be possible to accurately determine the magnitude of the change in the electric resistance increase rate during energization.

An object of the present disclosure is to provide an abnormality determination device, an abnormality determination method, and an abnormality determination system that can more accurately determine an abnormality of a heater.

### SOLUTIONS TO THE PROBLEMS

An abnormality determination device according to an aspect of the present disclosure includes:
an acquisition unit configured to acquire a resistance value of an electric heating element calculated from a voltage across the electric heating element of a heater and a current flowing through the electric heating element and configured to acquire a temperature value of the heater;
a first determination unit configured to perform an abnormality determination that is a determination of whether the heater is abnormal based on the acquired resistance value;
a second determination unit configured to determine whether or not the acquired temperature value is in a temperature settling state where the acquired temperature value is within a width with respect to a first target value; and
a third determination unit configured to determine whether or not the acquired resistance value is in a resistance settling state where the acquired resistance value is within a width with respect to a second target value, wherein
the first determination unit performs the abnormality determination when the second determination unit determines that the temperature settling state is established over a first period and the third determination unit determines that the resistance settling state is established over a second period.

An abnormality determination method according to an aspect of the present disclosure includes:
acquiring a resistance value of an electric heating element calculated from a voltage across the electric heating element of a heater and a current flowing through the electric heating element and acquiring a temperature value of the heater;
determining whether or not the acquired temperature value is in a temperature settling state where the acquired temperature value is within a width with respect to a first target value;
determining whether or not the acquired resistance value is in a resistance settling state where the acquired resistance value is within a width with respect to a second target value; and
performing an abnormality determination that is a determination of whether the heater is abnormal when it is determined that the temperature settling state is established over a first period and it is determined that the resistance settling state is established over a second period.

An abnormality determination system according to an aspect of the present disclosure includes:
a first device including
   a first acquisition unit configured to acquire a resistance value of an electric heating element of a heater calculated from a voltage across the electric heating element and a current flowing through the electric heating element, and
   a first determination unit configured to perform an abnormality determination that is a determination of whether the heater is abnormal based on the acquired resistance value;
a second device including
   a second acquisition unit configured to acquire a temperature value of the heater, and
   a second determination unit configured to determine whether or not the acquired temperature value is in a temperature settling state where the acquired temperature value is within a width with respect to a first target value and communicably connected to the first device; and
a third device including
   a third acquisition unit configured to acquire the resistance value of the electric heating element, and
   a third determination unit configured to determine whether or not the acquired resistance value is in a resistance settling state where the acquired resistance value is within a width with respect to a second target value, the third determination unit being communicably connected to the first device, wherein
the first acquisition unit is configured to acquire a determination result obtained by the second determination unit and a determination result obtained by the third determination unit, and
   the first determination unit performs the abnormality determination when the second determination unit determines that the temperature settling state is established over a first period and the third determination unit determines that the resistance settling state is established over a second period.

### EFFECTS OF THE INVENTION

According to the abnormality determination device according to the above aspect, it is possible to implement an abnormality determination device that can more accurately determine an abnormality of a heater.

According to the abnormality determination method according to the above aspect, an abnormality of a heater can be more accurately determined.

According to the abnormality determination system according to the above aspect, it is possible to implement an abnormality determination system that can more accurately determine an abnormality of a heater while coping with various embodiments.

### BRIEF DESCRIPTION OF THE DRAWINGS

Fig. 1 is a block diagram illustrating an abnormality determination device according to an embodiment of the present disclosure.
Fig. 2 is a diagram for explaining a temperature settling state of the abnormality determination device in Fig. 1.
Fig. 3 is a diagram for explaining a resistance settling state of the abnormality determination device in Fig. 1.
FIG. 4 is a first diagram for explaining a second target value setting process in the abnormality determination device in Fig. 1.
Fig. 5 is a second diagram for explaining a second target value setting process in the abnormality determination device in Fig. 1.
Fig. 6 is a flowchart for explaining an abnormality determination process in the abnormality determination device in Fig. 1.
Fig. 7 is a flowchart for explaining a target value setting process in the abnormality determination device in Fig. 1.

### DETAILED DESCRIPTION

An example of the present disclosure will be described below with reference to the accompanying drawings. In the following description, terms indicating specific directions or positions (for example, terms including "up", "down", "right", and "left") are used as necessary, but the use of these terms is to facilitate understanding of the present disclosure with reference to the drawings, and the technical scope of the present disclosure is not limited by the meanings of these terms. In addition, the following description is substantially a mere example and is not intended to limit the present disclosure, applicable objects thereof, and use thereof. Furthermore, the drawings are schematic, and the ratios of dimensions and the like do not necessarily match actual ones.

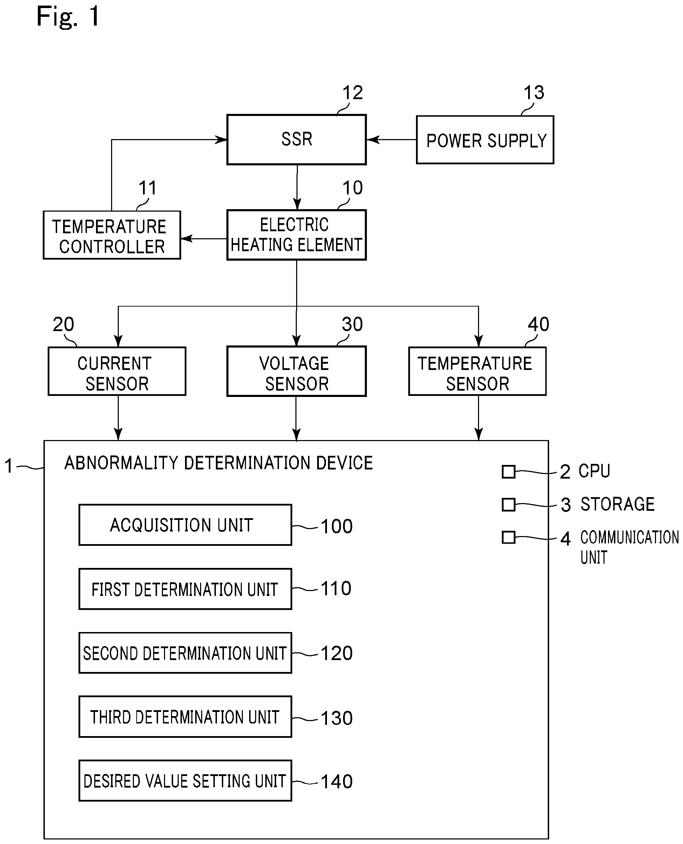

As an example, as illustrated in Fig. 1, an abnormality determination device 1 according to an embodiment of the present disclosure includes a CPU 2 configured to perform calculation, a storage 3, and a communication unit 4. The abnormality determination device 1 is configured to perform an abnormality determination for an electric heating element 10 of a heater. The storage 3 is configured to store information such as programs and data necessary for the abnormality determination for the electric heating element 10. The communication unit 4 is configured to input and output information to and from an external device connected in a wireless or wired manner. The electric heating element 10 is, for example, an electric heating wire of an electric resistance heater. A temperature controller 11 and an SSR (solid state relay) 12 are connected to the electric heating element 10, and a power supply 13 is connected to the solid state relay 12. The temperature controller 11 is configured to control on/off of the solid state relay 12. When the solid state relay 12 is on, a current from the power supply 13 is supplied to the electric heating element 10.

The abnormality determination device 1 includes an acquisition unit 100, a first determination unit 110, a second determination unit 120, a third determination unit 130, and a target value setting unit 140. Each of the acquisition unit 100, the first determination unit 110, the second determination unit 120, the third determination unit 130, and the target value setting unit 140 each is, for example, a function implemented by the CPU 2 executing a predetermined program.

The acquisition unit 100 is configured to acquire a resistance value of the electric heating element 10 and a temperature value of the heater calculated from a voltage across the electric heating element 10 of the heater and a current flowing through the electric heating element 10 via, for example, the communication unit 4. The resistance value of the electric heating element 10 is calculated by the CPU 2 or an external device (not illustrated) from a current value detected by a current sensor 20 and the voltage value detected by a voltage sensor 30, for example. The temperature value of the heater is detected by a temperature sensor 40, for example. The temperature sensor 40 is positioned near an object to be heat-treated (for example, a workpiece positioned in the casing of a heat treatment device including a heater) heated by the electric heating element 10, for example.

In the present embodiment, low-pass filter processing (for example, moving average processing) is applied to the acquired resistance value of the electric heating element 10. The low-pass filter processing on the resistance value of the electric heating element 10 is performed by the abnormality determination device 1 or an external device, for example. The number of times of moving averaging processing applied to the resistance value (to be referred to as a moving average count of a resistance value) is set according to a type of heater or the like.

The first determination unit 110 is configured to perform the abnormality determination that is the determination of whether the heater is abnormal based on the resistance value acquired by the acquisition unit 100. The abnormality determination is performed based on whether the acquired resistance value exceeds a preset threshold, for example. When the acquired resistance value exceeds the preset threshold, the first determination unit 110 determines that the heater is abnormal.

When it is determined that the heater is abnormal, for example, it is notified that deterioration of the heater or failure of the heater is suspected. At this time, a plurality of thresholds may be provided, and an abnormality of the heater may be notified in stages. For example, a value of 103% of a resistance reference value (= a second target value to be described later) is set as a first threshold, and a value of 105% of the resistance reference value is set as a second threshold. When the acquired resistance value exceeds the first threshold, it is notified that the deterioration state of the heater is the "caution" level. When the acquired resistance value exceeds the second threshold, it is notified that the deterioration state of the heater is the "alarm" level.

The first determination unit 110 performs the abnormality determination when the second determination unit 120 determines that the temperature settling state is established over a predetermined period and the third determination unit 130 determines that the resistance settling state is established over a predetermined period. In the present embodiment, the first determination unit 110 determines that the heater is in the settling state and performs the abnormality determination when it is determined that the temperature settling state is established over a period (an example of a first period) obtained by multiplying a cycle in which a resistance value is acquired by the moving average count of the resistance value (an example of a first period), and it is determined that the resistance settling state is established over a period obtained by multiplying the cycle in which the resistance value is acquired by the moving average count of the resistance value (an example of a second period) (in other words, when a stabilization condition is satisfied). A moving average count is set according to the type of heater or the like.

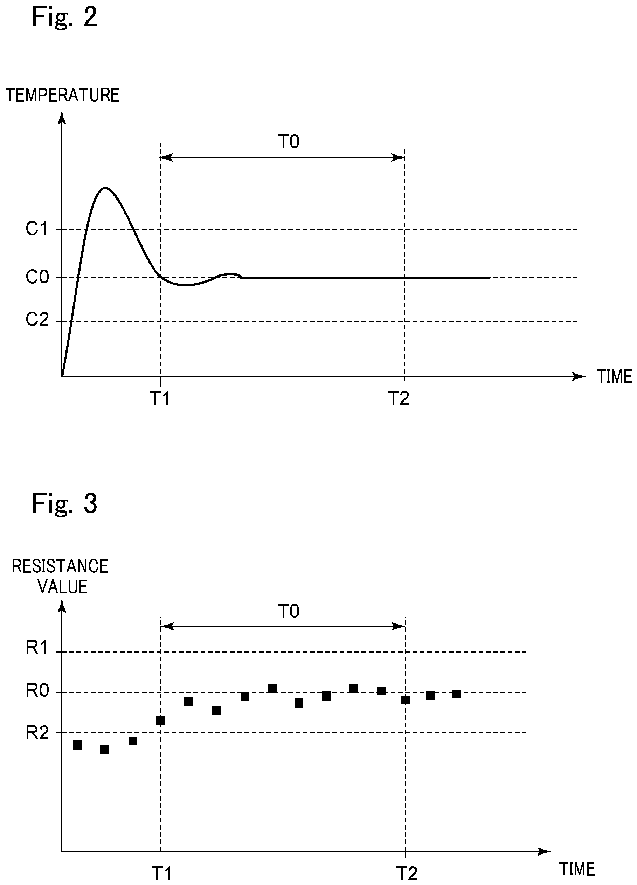

Fig. 2 illustrates an example in which a determination result all obtained by the second determination unit 120 is in the temperature settling state over the predetermined period. Fig. 3 illustrates an example in which a determination result all obtained by the third determination unit 130 is in the resistance settling state over the predetermined period. Referring to Figs. 2 and 3, the moving average count of the resistance values is set to 10. Referring to Fig. 2, a first target value which is a target temperature value is indicated by C0, an upper limit value of a width with respect to the first target value is indicated by C1, and a lower limit value of the width with respect to the first target value is indicated by C2. Referring to Fig. 3, the second target value which is the resistance reference value is indicated by R0, an upper limit value of a width with respect to the second target value is indicated by R1, and a lower limit value of the width with respect to the second target value is indicated by R2.

Referring to Fig. 2, the temperature value all acquired over a period T0 between time T1 and time T2 is located within the width with respect to the first target value C0. Referring to Fig. 3, the resistance value all acquired over the period T0 is located within the width with respect to the second target value R0. The first determination unit 110 performs the abnormality determination based on the resistance value acquired at or after time T2, but does not perform the abnormality determination and acquires a determination result obtained by the second determination unit 120 and the third determination unit 130 again when any one of the following conditions is satisfied.
· The case where a determination result acquired by the second determination unit 120 in the period T0 includes a determination that the temperature settling state is not established, or a determination result acquired by the third determination unit 130 in the period T0 includes a determination that the resistance settling state is not established.
· The case where a determination result acquired by the second determination unit 120 is a determination that the temperature settling state is not established, or a determination result acquired by the third determination unit 130 is a determination that the resistance settling state is not established.

The second determination unit 120 is configured to determine whether or not the acquired temperature value is in the temperature settling state where the acquired temperature value is within a width with respect to the first target value. In the present embodiment, the first target value is set in advance according to, for example, a design of the heater, a position of the temperature sensor 40, and a measurement target measured by the temperature sensor 40. The width with respect to the first target value is set to plus or minus 10°C of the first target value, for example. The upper limit value and the lower limit value of the width with respect to the first target value may or may not be included in "within the width with respect to the first target value".

The third determination unit 130 is configured to determine whether or not the acquired resistance value is in the resistance settling state where the acquired resistance value is within the width with respect to the second target value. In the present embodiment, the second target value is set by the target value setting unit 140. The width with respect to the second target value is set to plus or minus 1% of the second target value, for example. The upper limit value and the lower limit value of the width with respect to the second target value may or may not be included in "within the width with respect to the second target value".

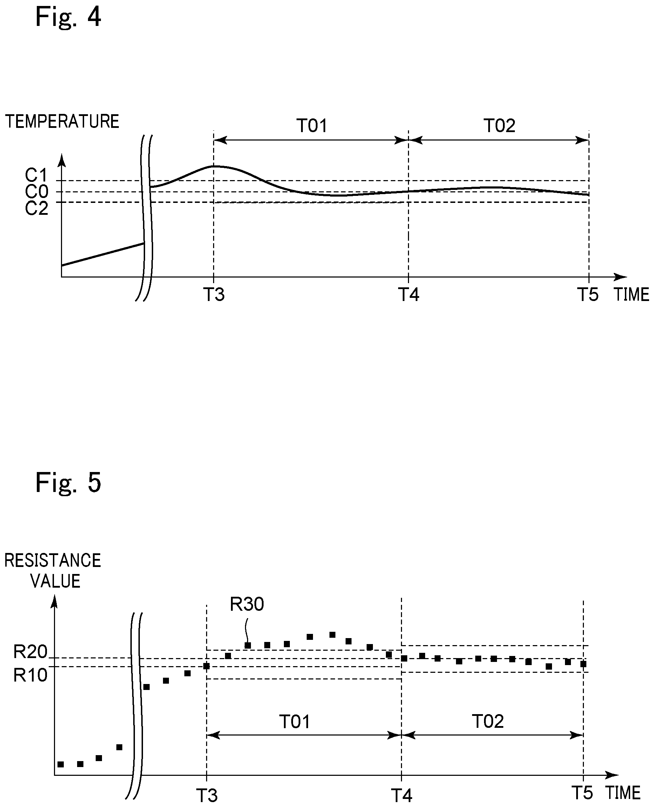

The target value setting unit 140 is configured to set the resistance value when setting of the second target value is started as a temporary second target value and is configured to set the temporary second target value as the second target value when it is determined that the temperature value all acquired within a predetermined period is within the width with respect to the first target value and the resistance value all acquired within a predetermined period is within a width with respect to the temporary second target value. For example, as illustrated in Fig. 5, when setting of the second target value is started from time T3, the target value setting unit 140 sets a resistance value R10 acquired at time T3 as the temporary second target value. In the present embodiment, when it is determined that the temperature value all acquired during a period obtained by multiplying the cycle in which the resistance value is acquired by the moving average count of the resistance value (an example of a third period) is within the width with respect to the first target value, and the resistance value all acquired during a period obtained by multiplying the cycle in which the resistance value is acquired by the moving average count of the resistance value (an example of a fourth period) is within the width with respect to the temporary second target value (in other words, when a setting condition for the second target value is satisfied), the temporary second target value is set as the second target value. The width with respect to the temporary second target value is set to plus or minus 1% of the temporary second target value, similarly to the second target value, for example.

When it is not determined that the temperature value all acquired within the predetermined period is within the width with respect to the first target value and the resistance value all acquired within the predetermined period is within the width with respect to the temporary second target value, the target value setting unit 140 resets the resistance value last acquired as the temporary second target value.

For example, as illustrated in Figs. 4 and 5, it is assumed that setting of the second target value is started from time T3, but the temperature value all acquired within a first period T01 is not within the width with respect to the first target value, and the resistance value all acquired within the first period T01 is not within the width with respect to the set temporary second target value. In this case, the target value setting unit 140 resets a resistance value R20 acquired last in the first period T01 as the temporary second target value. Referring to Figs. 4 and 5, the temperature value all acquired within a next period T02 is within the width with respect to the first target value and the resistance value all acquired within the next period T02 is within the width with respect to the resistance value R20 which is the reset temporary second target value. Thus, the target value setting unit 140 sets the resistance value R20 as the second target value. The resistance value acquired last is an average value of the resistance value acquired during a period. Thus, processing of setting the second target value can be shortened by resetting the resistance value acquired last in a period as the temporary second target value.

The number of times of resetting the temporary second target value (in other words, the number of times of determining whether or not the setting condition for the second target value is satisfied) may set an upper limit. For example, when the second target value has not been continuously set a predetermined number of times (for example, five times), the target value setting unit 140 does not reset the temporary second target value and stops the setting of the second target value.

When the acquired temperature value is in the temperature settling state and the acquired resistance value is in the resistance settling state, the target value setting unit 140 resets the second target value based on an average value of a plurality of the resistance values acquired most recently (for example, the moving average count). For example, the second target value is reset every time the resistance value is acquired a predetermined number of times (for example, the moving average count of the resistance value).

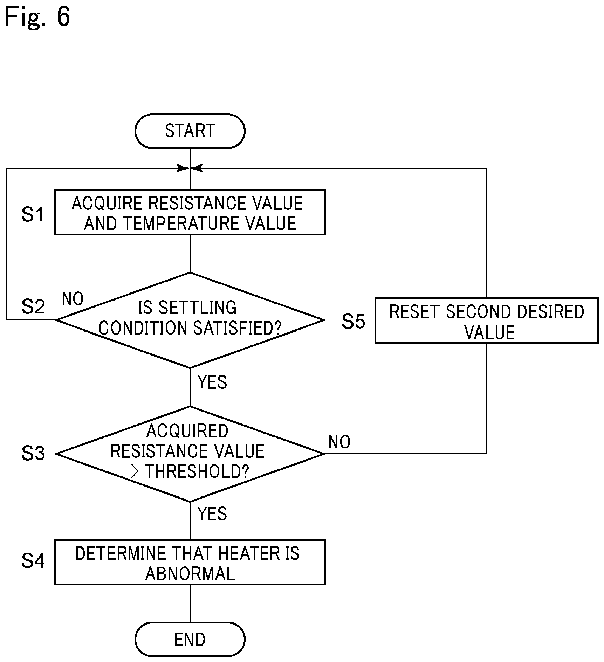

An abnormality determination process (an example of an abnormality determination method according to the present disclosure) of the abnormality determination device 1 will be described with reference to Fig. 6. Here, as an example, a case will be described in which the stabilization condition is satisfied when it is determined that a temperature settling state continues over the first period and it is determined that a resistance settling state continues over the second period, and the second target value is reset every time a resistance value is acquired once. The processing described below is executed by the CPU executing a predetermined program as an example.

As illustrated in Fig. 6, when the acquisition unit 100 acquires the resistance value and the temperature value of the electric heating element 10 (step S1), the first determination unit 110 determines whether or not the stabilization condition is satisfied, in other words, whether or not it is determined that the temperature settling state is established over the first period and it is determined that the resistance settling state is established over the second period (step S2). When it is not determined that the stabilization condition is satisfied, the first determination unit 110 does not perform the abnormality determination. Thereafter, the process returns to step S 1, and the resistance value and the temperature value of the electric heating element 10 are acquired.

When it is determined that the stabilization condition is satisfied, the first determination unit 110 performs the abnormality determination based on whether or not the acquired resistance value is larger than a threshold (step S3). When it is determined that the acquired resistance value is larger than the threshold, the first determination unit 110 determines that the heater is abnormal (step S4), and the abnormality determination process ends.

When it is determined that the acquired resistance value is equal to or less than the threshold, the target value setting unit 140 resets the second target value (step S5). Thereafter, the process returns to step S1, and the resistance value and the temperature value of the electric heating element 10 are acquired.

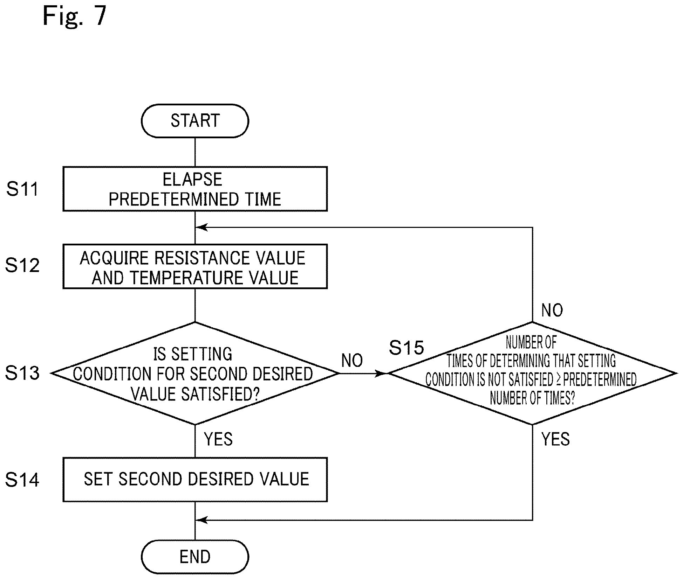

The target value setting process in the abnormality determination device 1 will be described with reference to Fig. 7. Here, as an example, a case will be described in which an upper limit is set to the number of times of determining whether or not the setting condition for the second target value is satisfied. The processing described below is executed by the CPU executing a predetermined program as an example.

As illustrated in Fig. 7, when a predetermined time is elapsed from a start of setting of the target value (step S 11) and the acquisition unit 100 acquires the resistance value and the temperature value of the electric heating element 10 (step S12), the target value setting unit 140 determines whether the setting condition for the second target value is satisfied (step S13).

When it is determined that the setting condition for the second target value is satisfied, the target value setting unit 140 sets the second target value (step S14), and the target value setting process ends.

When it is determined that the setting condition for the second target value is not satisfied, the target value setting unit 140 determines whether the number of times of determining that the setting condition is not satisfied is equal to or more than a predetermined number of times (for example, five times) (step S 15). When it is determined that the number of times of determining that the setting condition is not satisfied is equal to or more than the predetermined number of times, the target value setting unit 140 does not set the second target value, and the target value setting process ends. When it is determined that the number of times of determining that the setting condition is not satisfied is less than the predetermined number of times, the process returns to step S12, and the resistance value and the temperature value of the electric heating element 10 are acquired.

The abnormality determination device 1 can exhibit the following effects.

The abnormality determination device 1 includes the acquisition unit 100 configured to acquire the resistance value and the temperature value of the electric heating element 10, the first determination unit 110 configured to perform the abnormality determination that is the determination of whether or not the heater is abnormal based on the acquired resistance value, the second determination unit 120 configured to determine whether or not the acquired temperature value is in a temperature settling state where the acquired temperature value is within a width with respect to the first target value, and the third determination unit 130 configured to determine whether or not the acquired resistance value is in a resistance settling state where the acquired resistance value is within a width with respect to the second target value. The first determination unit 110 performs the abnormality determination when the second determination unit 120 determines that the temperature settling state is established over the first period and the third determination unit 130 determines that the resistance settling state is established over the second period. With such a configuration, it is possible to implement the abnormality determination device 1 that can more accurately determine an abnormality of the heater.

The low-pass filter processing is applied to the resistance value. With such a configuration, a resistance value can be easily settled.

The low-pass filter processing applied to the resistance value is moving average. With such a configuration, a resistance value can be easily settled.

The second period is the period obtained by multiplying a cycle in which resistance value is acquired by the moving average count of the resistance value. With such a configuration, it is possible to more accurately determine whether or not the heater is in the resistance settling state.

The abnormality determination device 1 includes the target value setting unit 140 configured to set a second target value. The target value setting unit 140 sets the resistance value when setting of the second target value is started as a temporary second target value, and sets the temporary second target value as the second target value when it is determined that the temperature value all acquired during the third period is within the width with respect to the first target value and the resistance value all acquired during the fourth period is within the width with respect to the temporary second target value. With such a configuration, the second target value can be set more accurately.

The target value setting unit 140 resets the resistance value acquired last as the temporary second target value when it is determined that the temperature value all acquired within the third period is within the width with respect to the first target value and the resistance value all acquired within the fourth period is not within the width with respect to the temporary second target value. With such a configuration, the second target value can be set more accurately.

The target value setting unit 140 resets the second target value based on an average value of last multiple times of the acquired resistance value when the acquired temperature value is in the temperature settling state and the acquired resistance value is in the resistance settling state. With such a configuration, it is possible to set a more accurate second target value according to a temporal change of the heater.

The moving average is applied to the resistance value, and the fourth period is a period obtained by multiplying a cycle in which resistance value is acquired by the moving average count of the resistance value. With such a configuration, it is possible to more accurately determine whether or not the heater is in the resistance settling state while easily stabilizing the resistance value.

According to the abnormality determination method according to the present disclosure, the following effects can be exhibited.

In the abnormality determination method, the resistance value of the electric heating element 10 calculated from the voltage across the electric heating element 10 of the heater and the current flowing through the electric heating element 10 is acquired, and the temperature value of the heater is acquired. It is determined whether or not the acquired temperature value is in a temperature settling state where the acquired temperature value is within a width with respect to the first target value. It is determined whether the acquired resistance value is in a resistance settling state where the acquired resistance value is within the width with respect to the second target value. The abnormality determination, which is the determination of whether the heater is abnormal, is performed when it is determined that the temperature settling state is established over the first period and it is determined that the resistance settling state is established over the second period. With such a configuration, an abnormality of the heater can be more accurately determined.

The abnormality determination device 1 may be configured as follows.

The first determination unit 110 may be configured to determine that the heater is in the settling state and perform the abnormality determination when all the following four conditions are satisfied.
· The temperature value all acquired within the first period is within the width with respect to the first target value (in other words, the heater is in the temperature settling state over the first period).
· The resistance value all acquired within the second period is within the width with respect to the second target value (in other words, the heater is in the resistance settling state over the second period).
· The acquired voltage value is equal to or more than a threshold.
· The acquired current value is equal to or more than a threshold.

For example, when an operation command for the abnormality determination device 1 is issued while the heater is not in operation, or when the heater is stopped after the operation command for the abnormality determination device 1 is issued, a condition that "the acquired voltage value is equal to or more than the threshold" is satisfied, and the abnormality determination is not performed.

The first determination unit 110 may stop the abnormality determination and acquire a determination result obtained by the second determination unit 120 and the third determination unit 130 again upon obtaining the determination that the temperature settling state is not established or the determination that the resistance settling state is not established.

The target value setting unit 140 may be omitted. In this case, the second target value is set in advance by a user, for example.

The target value setting unit 140 may be configured to set the temporary second target value as the second target value when all of the following four conditions are satisfied.
· The temperature value all acquired within the third period is within the width with respect to the first target value (in other words, the heater is in the temperature settling state over the third period).
· The resistance value all acquired within the fourth period is within the width with respect to the temporary second target value (in other words, the heater is in the resistance settling state over the fourth period).
· The acquired voltage value is equal to or more than a threshold.
· The acquired current value is equal to or more than a threshold.

For example, when an operation command for the abnormality determination device 1 is issued while the heater is not in operation, or when the heater is stopped after an operation command for the abnormality determination device 1 is issued, setting of the second target value is stopped based on a condition that "the acquired voltage value is equal to or more than the threshold". Since a voltage may temporarily decrease due to overshoot or the like, even when the acquired voltage value falls below a threshold, setting of each target value is not immediately stopped and is continuously performed except for a case in which all of the four conditions are not satisfied continuously a predetermined number of times.

The target value setting unit 140 may be configured to reset a resistance value when it is first determined that the acquired resistance value is not within the width with respect to the temporary second target value (for example, indicated by R30 in Fig. 5) as the temporary second target value.

The first period, the second period, the third period, and the fourth period may be periods having the same length or having different lengths. Any two or three of the first period, the second period, the third period, and the fourth period may be periods having the same length.

The first period and the third period each may be, for example, a period of an arbitrary length set by a user.

The second period and the fourth period each is not limited to the period obtained by multiplying a cycle in which resistance value is acquired by the moving average count of the resistance value and may be a period of an arbitrary length set by a user.

The resistance value acquired by the acquisition unit 100 may not be subjected to low-pass filter processing or may be subjected to low-pass filter processing other than moving average.

It may be configured as an abnormality determination system that the first determination unit 110, the second determination unit 120, and the third determination unit 130 are positioned in different devices such as servers. The abnormality determination system includes, for example, a first device in which the first determination unit 110 is positioned, a second device in which the second determination unit 120 is positioned, and a third device in which the third determination unit 130 is positioned. The acquisition unit 100 is provided in each of the first device, the second device, and the third device, the first device and the second device are connected to communicate in a wired or wireless manner, and the first device and the third device are connected to communicate in a wired or wireless manner. The acquisition unit of the first device acquires a determination result obtained by the second determination unit 120 and a determination result obtained by the third determination unit 130. With such a configuration, it is possible to implement the abnormality determination system that can more accurately determine an abnormality of the heater while coping with various embodiments.

The temperature sensor 40 may be positioned at an arbitrary position where the second determination unit 120 can determine whether the heater is in the temperature settling state, in other words, at a position where a temperature of the electric heating element 10 can be directly or indirectly detected. That is, a measurement target whose temperature is measured by the temperature sensor 40 may be the electric heating element 10, an object to be heat-treated, or an atmosphere around the electric heating element 10. For example, values measured according to the following aspects each may be set as "a temperature value of the heater".
· The temperature sensor 40 directly measures a temperature of the electric heating element 10.
· The temperature sensor 40 (for example, a thermocouple) measures a surface temperature of an object to be heat-treated heated by the electric heating element 10 (for example, a semiconductor wafer).
· The temperature sensor 40 measures an ambient temperature around an object to be heat-treated heated by the electric heating element 10 positioned in a furnace.

Various embodiments of the present disclosure have been described above in detail with reference to the drawings. Finally, various aspects of the present disclosure will be described. In the following description, as an example, reference numerals are also added.

An abnormality determination device 1 according to a first aspect of the present disclosure includes:
an acquisition unit 100 configured to acquire a resistance value of an electric heating element calculated from a voltage across the electric heating element 10 of a heater and a current flowing through the electric heating element 10 and configured to acquire a temperature value of the heater;
a first determination unit 110 configured to perform an abnormality determination that is a determination of whether the heater is abnormal based on the acquired resistance value;
a second determination unit 120 configured to determine whether or not the acquired temperature value is in a temperature settling state where the acquired temperature value is within a width with respect to a first target value; and
a third determination unit 130 configured to determine whether or not the acquired resistance value is in a resistance settling state where the acquired resistance value is within a width with respect to a second target value, wherein
the first determination unit 110 performs the abnormality determination when the second determination unit 120 determines that the temperature settling state is established over a first period and the third determination unit 130 determines that the resistance settling state is established over a second period.

In the abnormality determination device 1 according to a second aspect of the present disclosure,
low-pass filter processing is applied to the resistance value.

In the abnormality determination device 1 according to a third aspect of the present disclosure,
the low-pass filter processing applied to the resistance value is moving average.

In the abnormality determination device 1 according to a fourth aspect of the present disclosure,
the second period is a period obtained by multiplying a cycle in which the resistance value is acquired by a moving average count of the resistance value.

The abnormality determination device 1 according to a fifth aspect of the present disclosure includes
a target value setting unit 140 configured to set the second target value, wherein
the target value setting unit 140 sets the resistance value when setting of the second target value is started as a temporary second target value, and sets the temporary second target value as the second target value when it is determined that the temperature value all acquired during a third period is within the width with respect to the first target value and the resistance value all acquired during a fourth period is within a width with respect to the temporary second target value.

In the abnormality determination device 1 according to a sixth aspect of the present disclosure,
the target value setting unit 140 resets the resistance value acquired last as the temporary second target value when it is determined that the temperature value all acquired within the third period is within the width with respect to the first target value and the resistance value all acquired within the fourth period is not within the width with respect to the temporary second target value.

In the abnormality determination device 1 according to a seventh aspect of the present disclosure,
the target value setting unit 140 resets the second target value based on an average value of last multiple times of the acquired resistance value when the acquired temperature value is in the temperature settling state and the acquired resistance value is in the resistance settling state.

In the abnormality determination device 1 according to an eighth aspect of the present disclosure,
moving average is applied to the resistance value, and
the fourth period is a period obtained by multiplying a cycle in which the resistance value is acquired by a moving average count of the resistance value.

An abnormality determination method according to a ninth aspect of the present disclosure includes:
acquiring a resistance value of an electric heating element 10 calculated from a voltage across the electric heating element 10 of a heater and a current flowing through the electric heating element 10 and acquiring a temperature value of the heater;
determining whether or not the acquired temperature value is in a temperature settling state where the acquired temperature value is within a width with respect to a first target value;
determining whether or not the acquired resistance value is in a resistance settling state where the acquired resistance value is within a width with respect to a second target value; and
performing an abnormality determination that is a determination of whether the heater is abnormal when it is determined that the temperature settling state is established over a first period and it is determined that the resistance settling state is established over a second period.

An abnormality determination system according to a tenth aspect of the present disclosure includes:
a first device including
   a first acquisition unit configured to acquire a resistance value of an electric heating element 10 of a heater calculated from a voltage across the electric heating element 10 and a current flowing through the electric heating element 10, and
   a first determination unit 110 configured to perform an abnormality determination that is a determination of whether the heater is abnormal based on the acquired resistance value;
a second device including
   a second acquisition unit configured to acquire a temperature value of the heater, and
   a second determination unit 120 configured to determine whether or not the acquired temperature value is in a temperature settling state where the acquired temperature value is within a width with respect to a first target value and communicably connected to the first device; and
a third device including
   a third acquisition unit configured to acquire the resistance value of the electric heating element 10, and
   a third determination unit 130 configured to determine whether or not the acquired resistance value is in a resistance settling state where the acquired resistance value is within a width with respect to a second target value, the third determination unit being communicably connected to the first device, wherein
the first acquisition unit is configured to acquire a determination result obtained by the second determination unit 120 and a determination result obtained by the third determination unit 130, and
the first determination unit 110 performs the abnormality determination when the second determination unit 120 determines that the temperature settling state is established over a first period and the third determination unit 130 determines that the resistance settling state is established over a second period.

Note that, by appropriately combining arbitrary embodiments or modifications among the various embodiments or modifications described above, the effects of the respective embodiments or modifications can be achieved. In addition, combinations of embodiments, combinations of examples, or combinations of embodiments and examples are possible, and combinations of features in different embodiments or examples are also possible.

Although the present disclosure is fully described in connection with the preferred embodiments with reference to the accompanying drawings, various changes and modifications will be apparent to those skilled in the art. Such variations and modifications should be understood to be included within the scope of the present disclosure according to the appended claims as long as they do not depart therefrom.

### INDUSTRIAL APPLICABILITY

The abnormality determination device according to the present disclosure can be applied not only to an electric heater but also to a heater including an electric heating element that generates heat by resistance heating such as a fuse, a conductive wire, and a power transmission line.

The abnormality determination method according to the present disclosure can be applied not only to an electric heater but also to a heater including an electric heating element that generates heat by resistance heating such as a fuse, a conductive wire, and a power transmission line.

The abnormality determination system according to the present disclosure can be applied not only to an electric heater but also to a heater including an electric heating element that generates heat by resistance heating such as a fuse, a conductive wire, and a power transmission line.

### EXPLANATION OF REFERENCES

- 1: abnormality determination device
- 2: CPU
- 3: storage
- 4: communication unit
- 10: electric heating element
- 11: temperature controller
- 12: SSR
- 13: power supply
- 20: current sensor
- 30: voltage sensor
- 40: temperature sensor
- 100: acquisition unit
- 110: first determination unit
- 120: second determination unit
- 130: third determination unit
- 140: target value setting unit

## Claims

1. An abnormality determination device, comprising:
an acquisition unit configured to acquire a resistance value of an electric heating element calculated from a voltage across the electric heating element of a heater and a current flowing through the electric heating element and configured to acquire a temperature value of the heater;
a first determination unit configured to perform an abnormality determination that is a determination of whether the heater is abnormal based on the acquired resistance value;
a second determination unit configured to determine whether or not the acquired temperature value is in a temperature settling state where the acquired temperature value is within a width with respect to a first target value; and
a third determination unit configured to determine whether or not the acquired resistance value is in a resistance settling state where the acquired resistance value is within a width with respect to a second target value, wherein
the first determination unit performs the abnormality determination when the second determination unit determines that the temperature settling state is established over a first period and the third determination unit determines that the resistance settling state is established over a second period.

2. The abnormality determination device according to claim 1, wherein
low-pass filter processing is applied to the resistance value.

3. The abnormality determination device according to claim 2, wherein
the low-pass filter processing applied to the resistance value is moving average.

4. The abnormality determination device according to claim 3, wherein
the second period is a period obtained by multiplying a cycle in which the resistance value is acquired by a moving average count of the resistance value.

5. The abnormality determination device according to any one of claims 1 to 4, comprising
a target value setting unit configured to set the second target value, wherein
the target value setting unit sets the resistance value when setting of the second target value is started as a temporary second target value, and sets the temporary second target value as the second target value when it is determined that the temperature value all acquired during a third period is within the width with respect to the first target value and the resistance value all acquired during a fourth period is within a width with respect to the temporary second target value.

6. The abnormality determination device according to claim 5, wherein
the target value setting unit resets the resistance value acquired last as the temporary second target value when it is determined that the temperature value all acquired within the third period is within the width with respect to the first target value and the resistance value all acquired within the fourth period is not within the width with respect to the temporary second target value.

7. The abnormality determination device according to claim 5 or 6, wherein
the target value setting unit resets the second target value based on an average value of last multiple times of the acquired resistance value when the acquired temperature value is in the temperature settling state and the acquired resistance value is in the resistance settling state.

8. The abnormality determination device according to any one of claims 5 to 7, wherein
moving average is applied to the resistance value, and
the fourth period is a period obtained by multiplying a cycle in which the resistance value is acquired by a moving average count of the resistance value.

9. An abnormality determination method, comprising:
acquiring a resistance value of an electric heating element calculated from a voltage across the electric heating element of a heater and a current flowing through the electric heating element and acquiring a temperature value of the heater;
determining whether or not the acquired temperature value is in a temperature settling state where the acquired temperature value is within a width with respect to a first target value;
determining whether or not the acquired resistance value is in a resistance settling state where the acquired resistance value is within a width with respect to a second target value; and
performing an abnormality determination that is determination of whether the heater is abnormal when it is determined that the temperature settling state is established over a first period and it is determined that the resistance settling state is established over a second period.

10. An abnormality determination system, comprising:
a first device including
a first acquisition unit configured to acquire a resistance value of an electric heating element of a heater calculated from a voltage across the electric heating element and a current flowing through the electric heating element, and
a first determination unit configured to perform an abnormality determination that is a determination of whether the heater is abnormal based on the acquired resistance value;
a second device including
a second acquisition unit configured to acquire a temperature value of the heater, and
a second determination unit configured to determine whether or not the acquired temperature value is in a temperature settling state where the acquired temperature value is within a width with respect to a first target value and communicably connected to the first device; and
a third device including
a third acquisition unit configured to acquire the resistance value of the electric heating element, and
a third determination unit configured to determine whether or not the acquired resistance value is in a resistance settling state where the acquired resistance value is within a width with respect to a second target value, the third determination unit being communicably connected to the first device, wherein
the first acquisition unit is configured to acquire a determination result obtained by the second determination unit and a determination result obtained by the third determination unit, and
the first determination unit performs the abnormality determination when the second determination unit determines that the temperature settling state is established over a first period and the third determination unit determines that the resistance settling state is established over a second period.
